(19) Europäisches Patentamt
European Patent Office
Office européen des brevets

(11) **EP 2 159 818 B1**

(12) **EUROPÄISCHE PATENTSCHRIFT**

(45) Veröffentlichungstag und Bekanntmachung des Hinweises auf die Patenterteilung:
**18.03.2015 Patentblatt 2015/12**

(51) Int Cl.:
**_H01J 37/26_** _(2006.01)_

(21) Anmeldenummer: **08163121.0**

(22) Anmeldetag: **28.08.2008**

(54) **Elektronenmikroskop mit einer Phasenplatte**

Electron microscope with a phase plate

Microscope à électrons avec une lame de phase

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **27.08.2008 US 199675**

(43) Veröffentlichungstag der Anmeldung:
**03.03.2010 Patentblatt 2010/09**

(73) Patentinhaber: **Max-Planck-Gesellschaft zur Förderung der Wissenschaften e.V.**
**80539 München (DE)**

(72) Erfinder:
• **Barton, Bastian**
**60322, Frankfurt am Main (DE)**
• **Schröder, Rasmus R.**
**69118, Heidelberg (DE)**

(74) Vertreter: **Hannke, Christian**
**Hannke Bittner & Partner**
**Patent- und Rechtsanwälte**
**Prüfeninger Strasse 1**
**93049 Regensburg (DE)**

(56) Entgegenhaltungen:
EP-A- 1 845 551      EP-A- 1 959 475
EP-A1- 1 329 936      US-A- 5 814 815

• KUNIAKI NAGAYAMA: "Development of phase plates for electron microscopes and their biological application" EUROPEAN BIOPHYSICS JOURNAL ; WITH BIOPHYSICS LETTERS, SPRINGER, BERLIN, DE, Bd. 37, Nr. 4, 8. Februar 2008 (2008-02-08), Seiten 345-358, XP019586216 ISSN: 1432-1017

**Beschreibung**

Die Erfindung betrifft ein Elektronenmikroskop mit einer Phasenplatte, gemäß dem Oberbegriff des Patentanspruches 1.

Bei der Phasenkontrastmikroskopie handelt es sich um ein allgemein bekanntes mikroskopisches Verfahren zur Abbildung von Proben, die einen größeren Einfluss auf die Phase als auf die Amplitude einer Beleuchtungsstrahlung haben. Die Proben, die auch als Phasenobjekte bezeichnet werden, sind semitransparent. Durch Wechselwirkung des Probenmaterials mit der Beleuchtungsstrahlung wird die Phase der Beleuchtungsstrahlung beeinflusst.

In der optischen Mikroskopie, bei der die Beleuchtungsstrahlung Licht ist, ist die Phasenkontrastmikroskopie ein etabliertes Abbildungsverfahren. Mit einem Phasenring, der in der hinteren Brennebene des Objektivs eines Lichtmikroskops angeordnet ist, wird die von der Probe kommende Strahlung 0-ter Beugungsordnung relativ zur ersten Beugungsordnung phasenverschoben. Die Interferenz der höheren Beugungsordnungen mit dem phasenverschobenen Hauptmaximum liefert das gewünschte kontrastreiche Bild.

Eine derartige Phasenkontrastmikroskopie wurde auch für die Elektronenmikroskopie, bei der es sich bei der Beleuchtungsstrahlung um Elektronenwellen handelt, vorgeschlagen. Insbesondere beim Transmissionselektronenmikroskop (TEM), bei dem Proben mit Elektronen durchstrahlt und die Proben nach Durchgang der Elektronen durch die Probe elektronenoptisch abgebildet werden, besteht ein Interesse an physikalischen PhasenkontrastVerfahren, da notwendigerweise dünne, ungefärbte Proben untersucht werden, die sich durch eine geringe Phasenverschiebung auszeichnen.

In "Cryst. Res. Technol." von S. Zemlin, Bd. 33, 1998, S. 1097 - 1111 werden die Grundprinzipien der elektronenmikroskopischen Phasenkontrastverfahren erläutert. Zur Illustration werden Einzelheiten der wellenoptischen Beschreibung der Phasenkontrast-Elektronenmikroskopie genannt. Weitere Erläuterungen der Wellenoptik und Vektordarstellung des Phasenkontrastes ergeben sich insbesondere aus den hier angeführten Veröffentlichungen und Lehrbüchern der Elektronenmikroskopie.

Das mit dem strahlenoptischen System eines Elektronenmikroskopes in der Bildebene erzeugte vergrößerte Bild der Probe ergibt sich durch Interferenz von Elektronen, die einerseits an der Probe gebeugt werden und anderseits die Probe ungebeugt durchsetzen. Die Eigenschaften des Interferenzbildes können mit der Phasenkontrastübertragungsfunktion (phase contrast transfer function, PCTF) beschrieben werden. Die PCTF gibt an, welche Ortsfrequenzen der Probe aufgrund der instrumentellen Eigenschaften in welchem Maße von der Probe in das Bild übertragen werden. Für ein herkömmliches TEM mit Hellfeldabbildung ist die PCTF in erster Näherung eine Sinus-Funktion gemäß

$$PCTF(k) = 2\sin(\gamma(k)),$$

wobei k der Absolutbetrag des Wellenvektors (Ortsfrequenz) ist. Das Argument der Sinus-Funktion ist die Wellenaberration, die nicht-linear von k abhängt:

$$\gamma(k) = \pi/2\,(C_s\lambda^3 k^4 - 2\Delta z\,\lambda k^2),$$

wobei $C_s$ der sphärische Aberrationskoeffizient, $\lambda$ die Elektronenwellenlänge und $\Delta z$ der Defokuswert sind.

Die Ortsfrequenzabhängigkeit zeigt, dass niedrige Ortsfrequenzen (große Strukturen) im Bild wenig oder gar nicht aufgezeichnet werden. Daher erscheint das abgebildete Objekt mit besonders schwachem Kontrast. Die Kontrastübertragung verschwindet völlig in einem TEM ohne Linsenfehler ($C_s$ = 0mm) und für eine Bildaufnahme im Gauss-Fokus ($\Delta z$ = 0mm).

Um dennoch Kontraste zu erzeugen, werden gemäß der herkömmlichen Technik mit endlichem Koeffizienten der sphärischen Aberration ein kleiner Defokus eingestellt, was jedoch zu einem Informationsverlust durch eine Kontrastdelokalisierung führt.

Ein echtes Phasenkontrastverfahren beruht auf der Einführung der Phasenplatte in die hintere Brennebene der Objektivlinse des Elektronenmikroskops. Die Phasenplatte ist allgemein eine Vorrichtung, die bewirkt, dass zwischen dem gestreuten Wellenanteil und dem ungestreuten Wellenanteil eine zusätzliche Phasenverschiebung eingeführt wird. Beträgt diese 90°, so wird die PCTF in eine Kosinus-Funktion gemäß

$$PCTF_{\pi/2}(k) = 2\cos(\gamma(k))$$

überführt. Mit dieser PCTF kann auch unter optimalen optischen Bedingungen, nämlich vollständige Aberrationskorrektur und keine Defokussierung, eine vollständige Kontrastübertragung erfolgen. Es wird die maximale Bildinformation erzielt.

Ein generelles Problem des herkömmlichen Phasenkontrastverfahrens in der TEM besteht in der Einführung der Phasenplatte in den elektronenoptischen Strahlengang. Im Unterschied zum Einsatz eines Phasenringes bei der Lichtmikroskopie sind zusätzliche Einbauten bei der Elektronenmikroskopie in der Regel mit unerwünschten Signalverlusten oder Bildstörungen verbunden.

EP 1 329 936 offenbart ein Transmission-Elektronenmikroskop, wobei in einer zur Objektebene fouriertransformierten Ebene ein ringförmiges phasenschiebendes Element mit einer zentralen Öffnung angeordnet ist. Das ringförmige phasenschiebende Element erteilt dem Nullstrahl eine Phasenverschiebung, während die in Richtung der optischen Achse am Objekt gebeugte Strahlung höherer Beugungsordnungen die zentrale Öffnung des ringförmigen phasenschiebenden Elementes passiert und demzufolge vom phasenschiebenden Element nicht oder nur geringfügig beeinflusst wird.

Aus DE 101 14 949 A1 ist eine Dünnfilmphasenplatte für ein Phasenkontrastmikroskop bekannt. Die Dünnfilmphasenplatte besteht aus einem Dünnfilm, der an einer Blendenhalterung in der hinteren Brennebene des Objektives angeordnet ist. Der Dünnfilm enthält eine Durchtrittsöffnung, durch die ungestreute Elektronenwellen ungehindert hindurchtreten. Die von der Probe gestreuten Elektronenwellen hingegen werden durch die Elektronen-Materie-Wechselwirkung im Dünnfilm phasenverschoben. Der Dünnfilm soll die Aufladung eines Filmes, beispielsweise als Kohlefilm ausgebildet, verhindern, welcher durch sein inneres Potenzial die auftretende Phase manipuliert. Somit wird gezielt eine Aufladung eines Kohlefilms mit Hilfe des leitenden Filmes vermieden. Allerdings können am Dünnfilm nach Kontamination mit Verunreinigungen aus dem Elektronenmikroskop aufladungserscheinungen auftreten, die unkontrollierte Phasenverschiebungen und Bildverzerrungen bewirken und sich somit nachteilig bei Abbildungen auswirken. Dies ergibt eine Verminderung des Auflösungsvermögens, auch da der Film seine Funktion der Verhinderung einer Aufladung nicht mehr zuverlässig ausüben kann. Da bei der in DE 101 14 949 A1 beschriebenen Erfindung wird die Phasenverschiebung der Elektronenwelle durch das innere elektrostatische Potenzial eines nach außen ungeladenen Dünnfilms vonstatten geht, ist eine Dicke des Films von 20-30 nm erforderlich. Ein Film dieser Dicke führt jedoch beim Durchgang der Elektronenwelle zu Kohärenz- und damit zu Signalverlusten. Das Signal-zu-Rausch-Verhältnis der Bilder und die maximal erreichbare Auflösung werden dadurch vermindert.

Demzufolge ist es Aufgabe der Erfindung, eine Phasenplatte, insbesondere für ein Elektronenmikroskop sowie ein Elektronenmikroskop mit einer derartigen Phasenplatte zur Verfügung zu stellen, mit dem ein erhöhtes Signal-zu-Rausch-Verhältnis und somit eine erhöhte Auflösung erreicht wird.

Diese Aufgabe wird durch ein Elektronenmikroskop gemäß den Merkmalen des Patentanspruches 1 gelöst.

Ein wesentlicher Punkt der Erfindung liegt darin, dass bei einer Phasenplatte, insbesondere für ein Elektronenmikroskop, die in einer Elektronenstrahlbahn angeordnet ist und aus mindestens einer dünnen Folie besteht, welche zumindest teilweise für Elektronenstrahlen durchlässig ist, diese dünne Folie aus elektrisch leitfähigem Material besteht, an eine vorbestimmbare elektrische Spannung angeschlossen ist und mindestens eine Durchgangsöffnung aufweist. Durch das Anlegen einer äußeren Spannung U wird das Potenzial $\phi_a$ am Ort des leitenden Dünnflms ungleich dem Potenzial $\phi_0$ am Ausgang einer Elektronenquelle eines Elektronenmikroskopes und somit wird eine optimale Phasenverschiebung von $\pi/2$ erhalten, welche zwischen den Elektronen, die die Durchgangsöffnung passieren und den Elektronen, die die dünne Folie passieren, besteht. Dies führt dazu, dass die optimierte Phasenverschiebung von $\pi/2$ aufgrund der in der dünnen Folie verlangsamten Elektronen zu einer Abbildung mit maximalem Phasenkontrast führt.

Es kann durch das Anlegen einer derartigen Spannung zudem eine dünne Folie in Form eines Dünnfilms verwendet werden, deren Stärke bzw. Dicke auf beispielsweise 5 nm reduziert werden kann, wohingegen zuvor dünne Folien mit einer Dicke von beispielsweise 30 nm verwendet werden mussten, um eine derartige Phasenverschiebung anzustreben. Dies ermöglicht eine signifikant höhere Transmission und vermeidet Kohärenz- und Auflösungsverluste. Damit wird der Informationsgehalt des Bildes höher und die erreichbare Auflösung verbessert.

Die Phasenplatte ist vorzugsweise senkrecht zu einer optischen Achse des Elektronenmikroskops ausgerichtet und die Durchgangsöffnung erstreckt sich in Verlaufsrichtung der Elektronenstrahlenbahn, so dass ein ungehindertes Durchlaufen derjenigen Elektronen, die die Öffnung passieren sollen, stattfindet.

Die Durchgangsöffnung wird idealerweise im Zentrum einer Fläche der Phasenplatte, vorzugsweise in der optischen Achse eines Elektronenmikroskopes angeordnet.

Die Durchgangsöffnung kann sowohl kreisförmig in ihrem Querschnitt mit einem bestimmten Radius aus einem Bereich von 0,1 - 20 $\mu$m, vorzugsweise von 0,3 - 0,8 $\mu$m als auch rechteckförmig ausgebildet sein. Selbstverständlich sind auch andere Querschnittsflächen für die Durchgangsöffnung denkbar.

Die Phasenplatte ist gemäß einer bevorzugten Ausführungsform in einer bezüglich eines zu beobachtenden Objektes der hinteren Brennebene einer Objektivlinse eines TransmissionsElektronenmikroskopes angeordnet, so dass ein gezielter Durchtritt der Elektronen sowohl durch die Durchgangsöffnung als auch durch die umliegende Materie der dünnen Folie erfolgen kann.

Vorzugsweise ist die dünne Folie zumindest teilweise auf einem Trägerfilm, der vorzugsweise aus amorphem Material besteht, angeordnet. Dies bewirkt nicht nur eine stabilisierte Anbringung der dünnen Folie in der hinteren Brennebene eines Elektronenmikroskops, sondern auch eine optimale Ausrichtung der Folie im Verhältnis zu der Ausrichtung der Elektronenstrahlbahn.

Die dünne Folie selber ist aus einem amorphen Material, wie Gold, Aluminium, Silber, Platin, Titan oder Legierungen hieraus, um die elektrische Leitfähigkeit der Folie aufgrund der angelegten Spannung sicherzustellen.

Die dünne Folie weist gemäß einer bevorzugten Ausführungsform eine Foliendicke aus einem Bereich von 0,1 - 50 nm, vorzugsweise von 0,3 - 1,0 nm auf, wobei der darunterliegende Trägerfilm eine Filmdicke aus einem Bereich von 1 - 100 nm, vorzugsweise von 5 - 20 nm aufweisen kann.

Die Phasenplatte kann auch in einem Verbund von entlang der Elektronenstrahlbahn übereinander angeordneten Phasenplatten angeordnet sein, wobei die Phasenplatte sowohl in diesem Verbund als auch bei einzelner Verwendung zumindest Teile, nämlich vorzugsweise eine Halbebene einer Beugungsbildebene innerhalb des Elektronenmikroskopes abdecken kann.

Ein Elektronenmikroskop mit einer derartigen Phasenplatte ist derart vorteilhaft ausgebildet, dass es zumindest eine Objektivlinse, die Phasenplatte, eine an der Phasenplatte angelegte Spannung mit dazugehöriger Spannungsquelle, ein Objekt in einer Objektebene und ein Beleuchtungssystem umfasst.

Weitere vorteilhafte Ausführungen ergeben sich aus den Unteransprüchen.

Vorteile und Zweckmäßigkeiten sind der nachfolgenden Beschreibung in Verbindung mit der Zeichnung zu entnehmen. Hierbei zeigen:

Fig.1       in einer schematischen Darstellung ein Elektronenmikroskop mit einer Phasenplatte gemäß einer ersten Ausführungsform der Erfindung;

Fig. 2       in einer schematischen Darstellung ein Ausschnitt eines Elektronenmikroskopes mit einer Phasenplatte gemäß einer zweiten Ausführungsform der Erfindung.

Fig. 3       in einer schematischen Ausschnittsdarstellung ein Elektronenmikroskop mit einer Phasenplatte gemäß einer dritten Ausführungsform;

Fig. 4       in einer schematischen Ausschnittsdarstellung ein Elektronenmikroskop mit einer Phasenplatte gemäß einer vierten Ausführungsform der Erfindung;

Fig. 5       in einer ausschnittsweisen schematischen Darstellung ein Elektronenmikroskop mit Phasenplatten gemäß einer fünften Ausführungsform der Erfindung;

Fig. 6       in einer schematischen Darstellung ein Elektronenmikroskop mit Phasenplatten gemäß einer sechsten Ausführungsform der Erfindung;

Fig. 7       in einem Diagramm eine Darstellung der durch die Phasenplatte des erfindungsgemäßen Elektronenmikroskops erreichten Phasenverschiebung;

Fig. 8       ein Ausschnitt der in Fig. 7 wiedergegebenen Darstellung;

Fig. 9       in einem Diagramm eine weitere Darstellung der mit der Phasenplatten erreichten Phasenverschiebung;

Fig. 10       ein Ausschnitt der in Fig. 9 wiedergegebenen Darstellung; und

Fig. 11       zwei Bildaufnahmen mit und ohne der in einem Transmissionselektronenmikroskop eingebauten Phasenplatte.

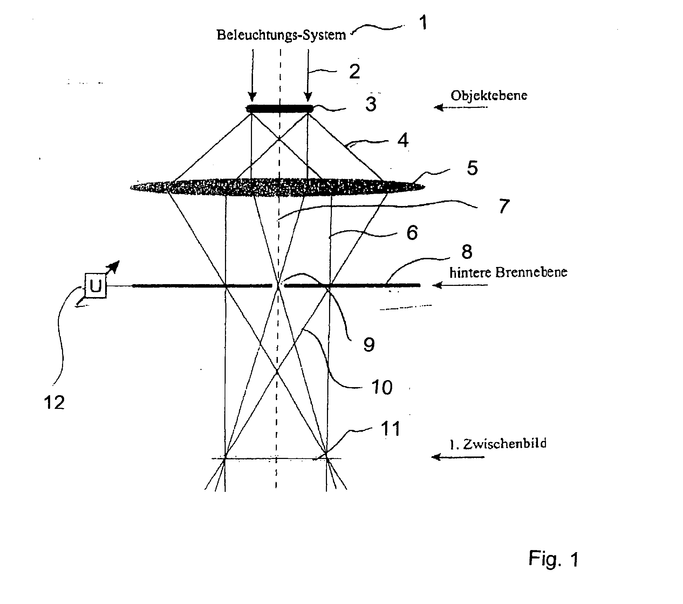

In Fig. 1 wird in einer schematischen Darstellung ein Transmissionselektronenmikroskop (TEM) mit einer Phasenplatte gemäß einer ersten Ausführungsform der Erfindung dargestellt. Von einem Beleuchtungssystem 1 aus fallen Elektronenstrahlen 2 auf ein Objekt 3, an welchem die Elektronenstrahlen gemäß Bezugszeichen 4 gestreut werden. Anschließend fallen die gestreuten Elektronenstrahlen 4 auf eine Objektivlinse 5, die zunächst ein Beugungsmuster und dann ein Zwischenbild des Objektes erzeugt. Eine Phasenplatte 8 ist in der Nähe der hinteren Brennebene der Objektivlinse 5 positioniert, genauer an dem Ort, an dem das von der Linse gesammelte Bündel der ungestreuten Strahlen die geringste Ausdehnung senkrecht zu einer optischen Achse 7 hat (="Crossover").

Die an der Objektivlinse 5 gesammelten Elektronenstrahlen werden anschließend gemäß Bezugszeichen 6 durch die Phasenplatte 8 hindurchgeleitet, wobei bestimmte Elektronenstrahlen eine Durchgangsöffnung bzw. ein Loch 9 durchlaufen und andere Elektronenstrahlen, die dünn ausgeprägte Phasenplatte 8 und deren Materie durchlaufen.

An der Phasenplatte 8 ist eine Spannung mittels einer Spannungsquelle 12 von außerhalb angelegt.

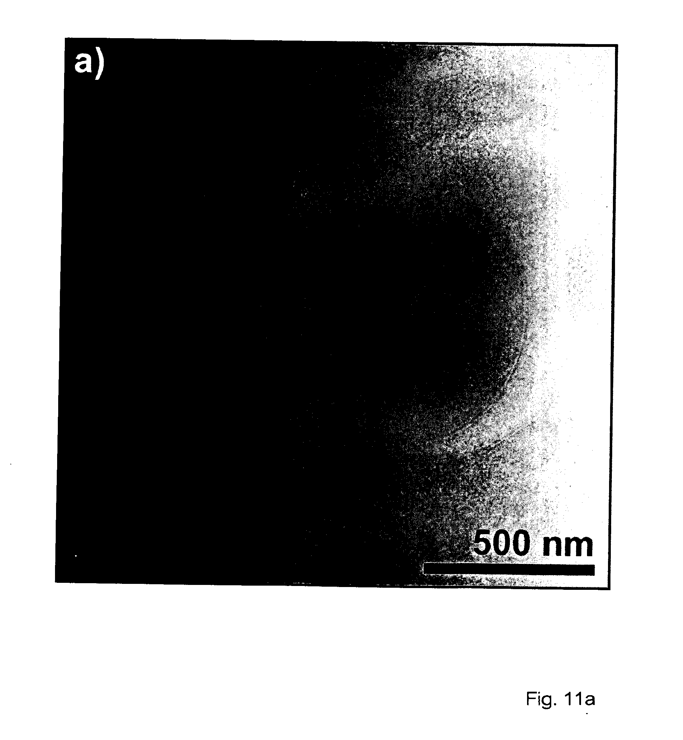

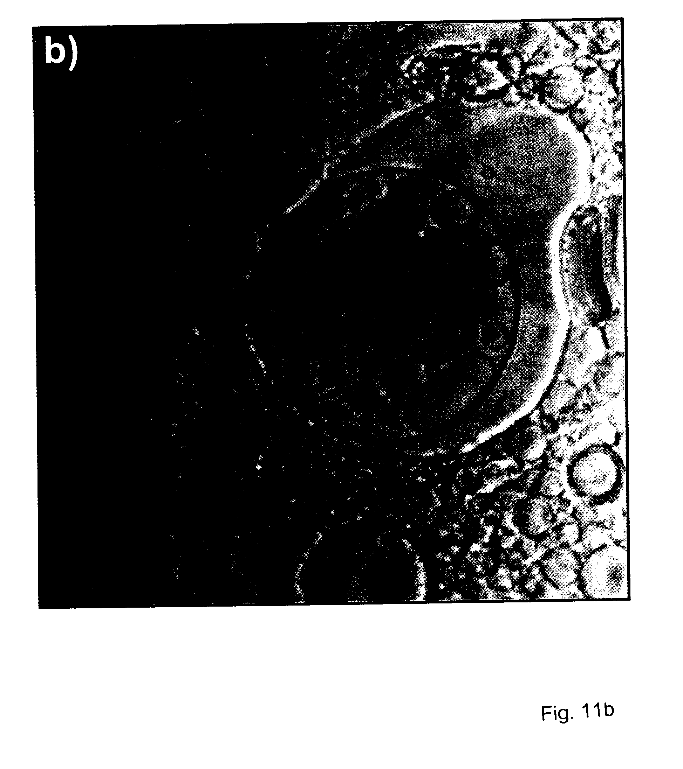

Die durch die Phasenplatte 8 oder durch dessen Durchgangsöffnung 9 hindurchgetretenen Elektronenstrahlen 10 fallen anschließend in einer Zwischenbildebene auf eine Bildebene 11, um ein entsprechendes Phasenkontrast-Bild, welches durch den in Durchtritt der Elektronenstrahlen durch die Phasenplatte 8 erhalten wird, zu erhalten. Dies wird zu einem kontrastreichen Bild, wie es beispielsweise aus Fig. 11b durch einen Vergleich mit der in Fig. 11a wiedergegebenen Abbildung, die nicht mit der erfindungsgemäßen Phasenplatte erhalten wurde, hervorgeht.

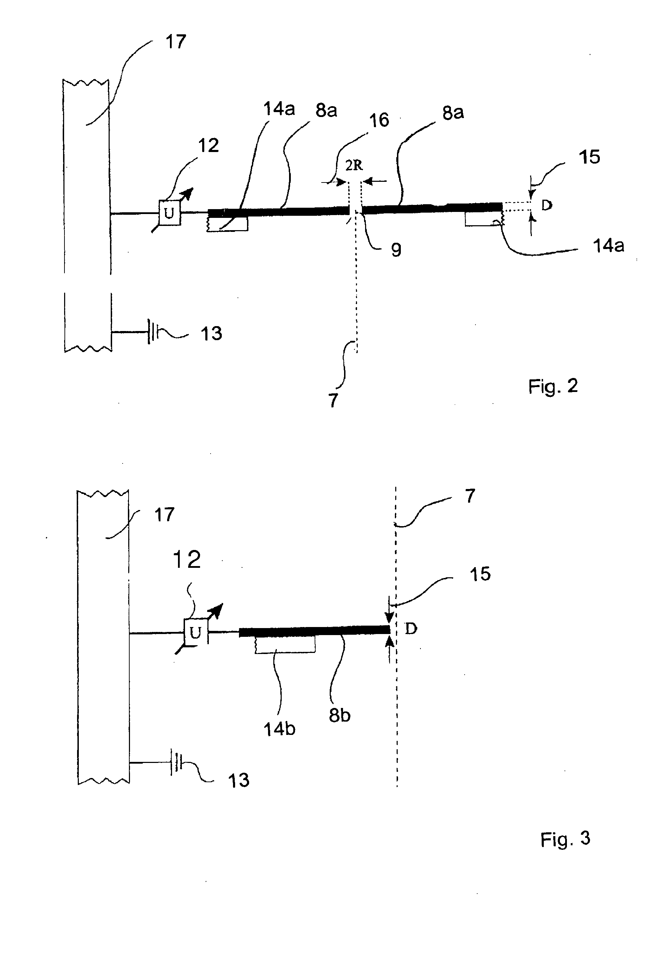

In Fig. 2 ist in einer Ausschnittsdarstellung schematisch ein Elektronenmikroskop mit einer Phasenplatte gemäß einer zweiten Ausführungsform der Erfindung dargestellt. Gleiche und gleichbedeutende Teile sind mit gleichen Bezugszeichen versehen.

Die Phasenplatte 8a ist wiederum mit einem elektrischen Potenzial gemäß der Spannungsquelle 12, welches ungleich dem Potenzial am Ausgang der Elektronenquelle des TEM ist und durch das Erdpotenzial 13 wiedergegeben wird, versehen. Die Phasenplatte 8a weist die zentral angeordnete Durchgangsöffnung 9 auf, wobei diese Durchgangsöffnung einen kreisförmigen Querschnitt mit einem Durchmesser 16, der vorzugsweise 1,0 $\mu$m aufweist, zeigt. Die Durchgangsöffnung ist in der Nähe der hinteren Brennebene der Objektivlinse positioniert, genauer an dem Ort, an dem das von der Linse gesammelte Bündel der ungestreuten Strahlen die geringste Ausdehnung senkrecht zur optischen Achse hat, hier als auf der optischen Achse liegend wiedergegeben.

Die Phasenplatte 8a wird beidseitig zumindest teilweise von einem Trägerfilm 14a zu Stabilisierungszwecken gehalten, wobei der Trägerfilm beispielsweise ringförmig ausgebildet sein kann.

Die dünne Folie 8a der Phasenplatte weist eine Dicke 15 von beispielsweise 5 nm auf.

Das Transmissionselektronenmikroskop ist durch eine linksseitig angedeutete Außenwand 17 wiedergegeben.

Die Phasenplatte wird in der hinteren Brennebene, genauer an dem Ort, an dem das von der Linse gesammelte Bündel der ungestreuten Strahlen die geringste Ausdehnung senkrecht zur optischen Achse hat, eines Transmissionselektronenmikroskopes positioniert. Der Zentralstrahl der ungestreuten Elektronen wird durch das zentrale Loch geführt, wohingegen gestreute Elektronen den dünnen Film 8a aus leitendem und elektronendurchlässigem Material passieren. Durch die angelegte Spannung entsteht eine Potentialverteilung, wie sie nachfolgend noch näher dargelegt wird, woraufhin die Elektronwelle phasenverschoben wird, was zu starken Phasenkontrast in der fokussierten Abbildung, gemäß Fig. 11, der Probe bzw. des Objektes 3 führt.

In Fig. 3 ist ausschnittsweise eine schematische Darstellung eines Elektronenmikroskopes mit einer Phasenplatte gemäß einer dritten Ausführungsform der Erfindung gezeigt. Die Phasenplatte 8b ist lediglich auf einer Halbebene bezüglich der optischen Achse 7 angeordnet und weist wiederum einen Trägerfilm 14b auf. Gleiche und gleichbedeutende Bauteile sind mit gleichen Bezugszeichen versehen.

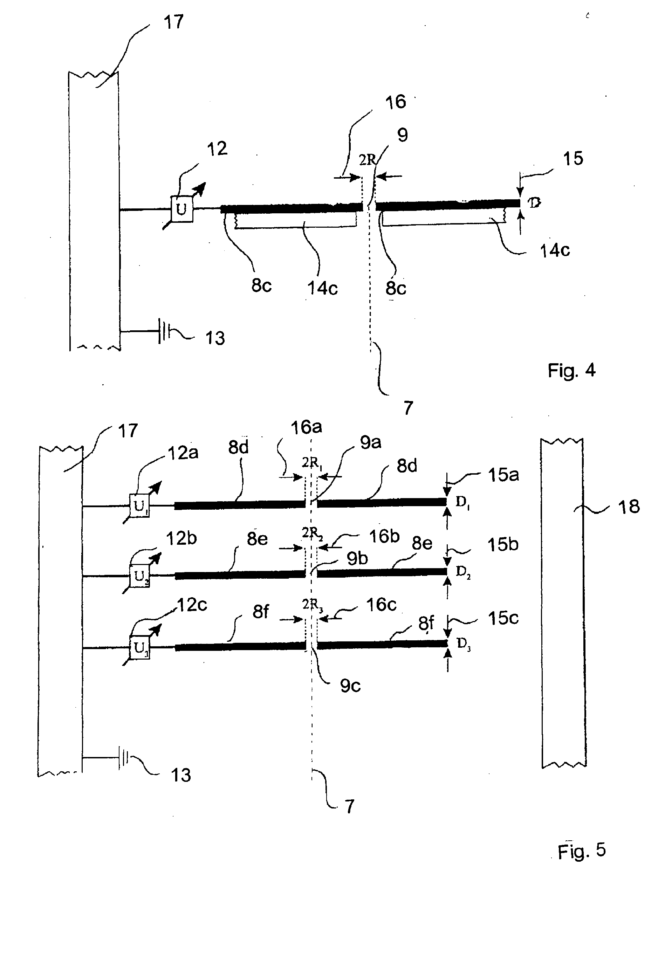

In Fig. 4 wird eine vierte Ausführungsform der Phasenplatte in einem ausschnittsweise dargestellten schematisch wiedergegebenen Transmissionselektronenmikroskops gezeigt. gleiche und gleichbedeutende Teile sind wiederum mit gleichen Bezugszeichen versehen.

Die Phasenplatte bzw. die dünne Folie 8c weist nahezu über ihre gesamte untere Fläche einen Trägerfilm 14c auf, der beispielsweise aus Kohlenstoff bestehen kann und beispielsweise 10 nm dick ist.

Die dünne Folie 8c selber kann beispielsweise 5 nm dick sein.

Bei der Spannung 12 werden Werte von beispielsweise 100 mV verwendet, wobei diese Werte ebenso auf die weiteren Ausführungsformen der erfindungsgemäßen Phasenplatte angewendet werden können. Vorteilhaft ist die dünne Folie 8c aus Silber, Aluminium, Gold, Titan oder dergleichen Materialien, um eine leitende Struktur und zugleich eine möglichst geringe Beeinflussung der diesen Film durchdringenden Elektronen zu erhalten.

In Fig. 5 ist eine fünfte Ausführungsform der Phasenplatte mit angedeuteten ausschnittsweisen Elektronenmikroskop wiedergegeben. Hier handelt es sich um einen Verbund von zwei oder mehreren Phasenplatten mit den dünnen Folien 8d, 8e und 8f und darin auf der optischen Achse 7, genauer an dem Ort, an dem das von der Linse gesammelte Bündel der ungestreuten Strahlen die geringste Ausdehnung senkrecht zur optischen Achse 2 hat, angeordneten Löchern 9a, 9b und 9c, wobei die Löcher 9a, 9b und 9c den gleichen Durchmesser oder verschiedene Durchmesser 16a, 16b und 16c aufweisen können.

An jeder Phasenplatte ist eine Spannungsquelle 12a, 12b und 12c angeschlossen, um ein elektrisches Potenzial am Ort des Filmes der Phasenplatte 12 zu erhalten.

Ebenso können die Phasenplatten entweder gleich stark oder unterschiedliche Dicken 15a, 15b und 15c aufweisen.

Das Elektronenmikroskop ist mit links- und rechtsseitigen Wänden 17, 18 andeutungsweise dargestellt.

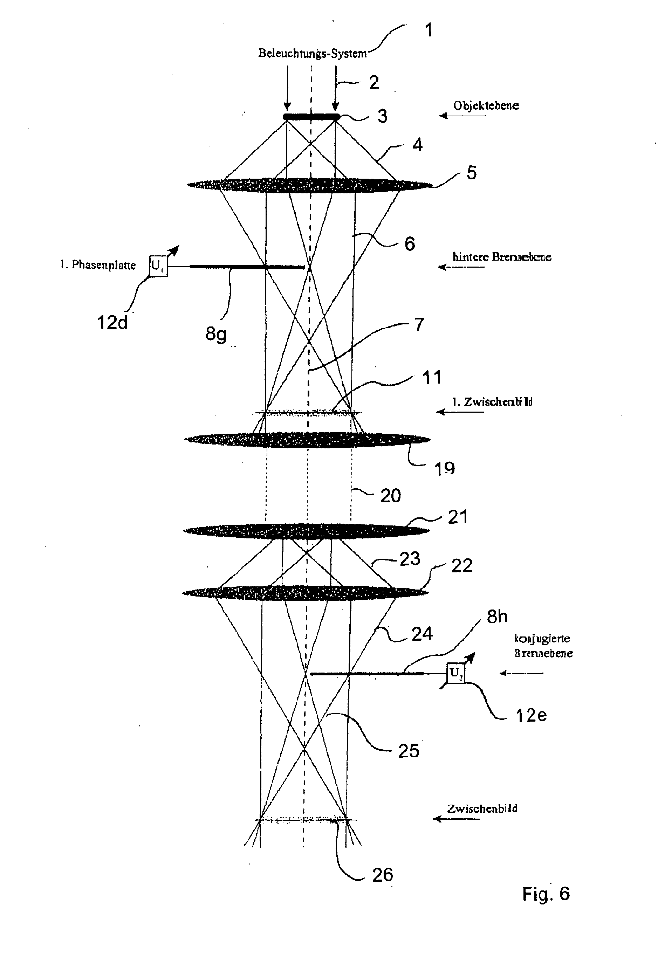

In Fig. 6 ist eine weitere sechste Ausführungsform der Phasenplatte mit dazugehörigem Elektronenmikroskop bzw. Transmissionselektronenmikroskop dargestellt. Gleiche und gleichbedeutende Bauteile sind mit gleichen Bezugszeichen versehen.

Nachdem die Elektronen die Objektivlinse 5, welche eine Sammellinse ist, durchlaufen haben, treten sie in eine halbseitig bezüglich der optischen Achse angeordnete Phasenplatte 8g ein und werden mittels dieser Phasenplatte zumindest auf dieser linken Seite des Elektronenmikroskopes gestreut bzw. gebeugt. An der Phasenplatte 8g liegt eine Spannung mittels der Spannungsquelle 12d an.

Eine weitere Phasenplatte 8h ist in der anderen Hälfte des Transmissionselektronenmikroskopes bezüglich der optischen Achse 7 angeordnet und weist eine zweite Spannung mittels der zweiten Spannungsquelle 12e auf, wobei die Spannungen der Spannungsquellen 12d und 12e gleich groß oder verschieden sein können.

In einem ersten Zwischenbild wird wiederum das Bild der Phasenverschiebung erhalten. Anschließend durchlaufen die Elektronenstrahlen eine weitere Objektivlinse 19, die in einem Transferlinsensystem mit einer weiteren Linse 21, 22 ausgestattet sind und zudem weitere Linsen und dergleichen Elemente, wie durch Bezugszeichen 20 angedeutet, aufweisen können.

Die durch die Linse 21 hindurchgetretenen Elektronenstrahlen 23 durchlaufen die abbildende Linse 22 und treten dann als Elektronenstrahlen 24 aus dieser aus, um anschließend teilweise in die Phasenplatte 8h einzutreten und somit als Elektronenstrahlen 25 teilweise eine Phasenverschiebung von $\pi/2$ aufzuweisen, wenn sie in der Zwischenbildebene 26 ein Bild erzeugen.

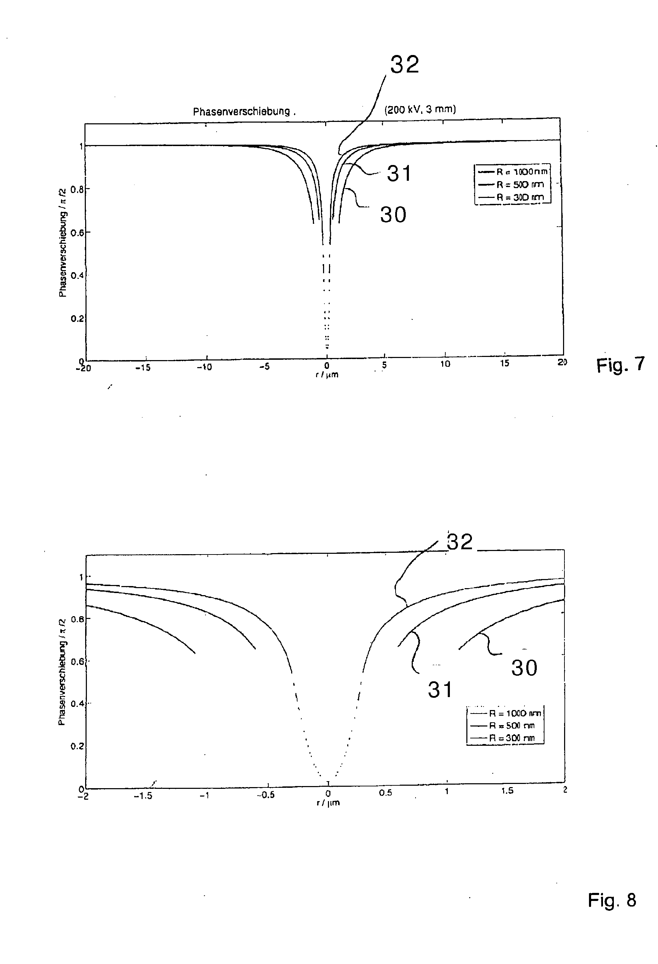

In Fig. 7 ist in einem Phasenverschiebungsdiagramm die Phasenverschiebung, welche durch eine Phasenplatten-Anordnung gemäß Fig. 1 - 6 erhalten werden kann, dargestellt.

In Fig. 8 ist eine vergrößerte Darstellung des zentralen Bereiches des Diagramms gemäß Fig. 7 wiedergegeben.

Über die Ordinate ist die Phasenverschiebung in Einheiten von $\pi/2$ und über die Abszisse der Abstand von der optischen Achse angegeben, wobei die Durchgangsöffnung um den 0-Wert herum angeordnet ist.

Gemäß Bezugszeichen 30 wird ein Phasenverschiebungsverlauf bei einer Phasenplatte mit einer Durchgangs-öffnung von 1 $\mu$m gezeigt. Das Bezugszeichen 31 gibt einen Phasenverschiebungsverlauf für eine Phasenplatte mit einem Durchgangsöffnungsradius von 500 nm und Bezugszeichen 32 für eine Phasenplatte mit einem Durchgangsöffnungsradius von 300 nm. Die hierin gezeigte relative Phasenverschiebung von ungestreuten zu gestreuten Elektronenwellen aufgrund der Phasenplatte in Abhängigkeit vom Durchgangsabstand von der optischen Achse zeigt, dass der gewünschte Phasenverschiebungsverlauf umso schneller eintritt, je kleiner der Radius der Durchgangsöffnung ist. Die an der Phasenplatte angelegte Spannung ist hierbei jeweils so eingestellt, dass für die Phasenverschiebung große Abstände von der optischen Achse immer 90° beträgt.

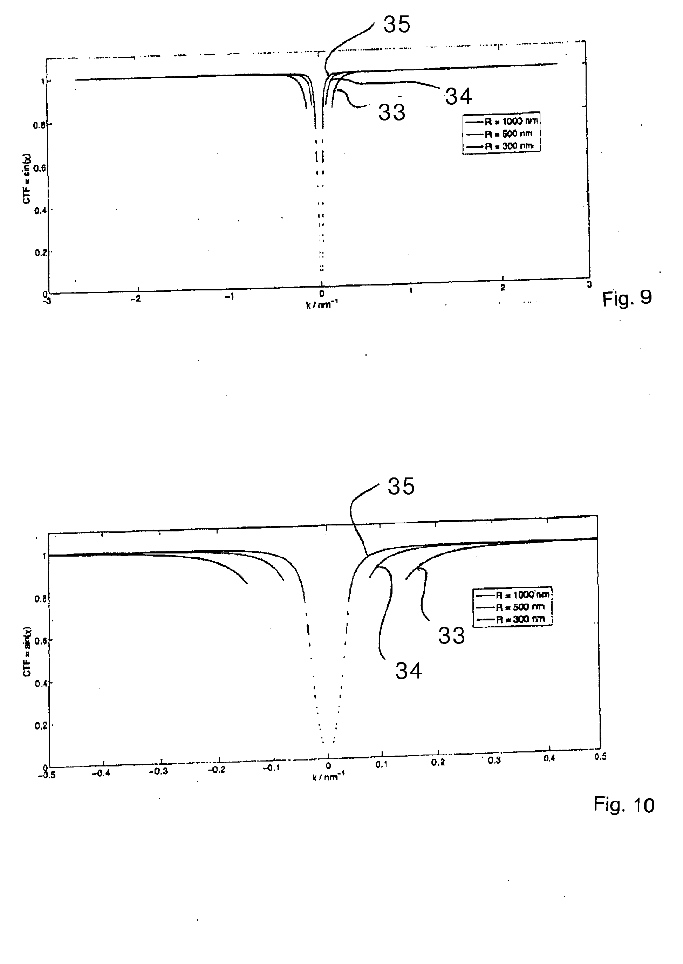

In Fig. 9 und in einer vergrößerten Darstellung in Fig. 10 ist in einem Diagramm die Phasenkontrast-Übertragung für Phasenplatten mit Durchgangsöffnungen, die verschiedene Radien aufweisen, wiedergegeben. Hierbei wird die Phasenkontrast-Transfer-Funktion (PCTF) in Abwesenheit aller anderen Linsenaberrationen, d.h. es wird das Aufnahmeobjekt im Gauss-Fokus betrachtet und sämtliche höheren Aberrationen vernachlässigt, bei Durchgang des ungestreuten Zentralstrahls durch das Phasenplatten-Loch bei drei verschiedenen Lochradien gezeigt. Der Phasenkontrast erreicht sehr schnell einen nahezu optimalen Wert von mehr 80% gemäß nachfolgender Tabelle in Abhängigkeit von der Ortsfrequenz der Strukturfaktoren des Objekts in der Beugungsebene. Im Gegensatz zu der Verwendung eines nach außen ungeladenen Filmes als Phasenplatte wird hier eine Erhöhung des Kontrastes auch für solche Ortsfrequenzen erreicht, die Achsenabständen r innerhalb des zentralen Loches entsprechen.

Nachfolgend wird die physikalische Erklärung der Funktionsweise der Phasenplatten wiedergegeben:

Phasenplatten wiedergegeben:

Das elektrische Feld $E$ ober- und unterhalb der Phasenplatte wird als homogen angenommen,

$$(1) \qquad -E_1 = E_2 = E > 0$$

Das Potenzial ist:

$$(2) \qquad \Phi(r,z) = \Phi_0 - \frac{2E}{\pi}|z| \left( \arctan \mu + \frac{1}{\mu} \right)$$

mit

$$(3) \quad \mu = \left[ \left( \frac{z^2}{2R^2} + \frac{r^2}{2R^2} - \frac{1}{2} \right) + \left\{ \frac{4z^2}{2R^2} + \left( \frac{z^2}{R^2} + \frac{r^2}{R^2} - 1 \right)^2 \right\}^{\frac{1}{2}} \right]^{\frac{1}{2}} .$$

Dabei sind z die Koordinate entlang der optischen Achse des TEM (Phasenplatten-Ebene bei z = 0) und *R* der Radius des Phasenplatte-Lochs.

Auf der Symmetrieachse (r = 0) gilt:

$$(4) \quad \Phi_{ax} = \Phi_0 - \frac{2E}{\pi} R \left( \frac{z}{R} \arctan \frac{z}{R} + 1 \right).$$

Die Phasenverschiebung bei ablenkungsfreiem Durchgang der Elektronen durch die Phasenplatte mit Abstand r von der optischen Achse ist

$$(5) \quad X(r) = \frac{\pi e}{\lambda U} \frac{m_e c^2 + eU}{m_e c^2 + eU/2} \int_{-\infty}^{+\infty} \phi(r,z) dz$$

(e: Elementarladung, $\lambda$: DeBroglie-Wellenlänge der Elektronen, U: Beschleunigungsspannung des TEM, $m_e C_2$: Ruheenergie des Elektrons) und auf der optischen Achse (r =0)

$$(6) \quad X_{ax} = \frac{\pi e}{\lambda U} \frac{m_e c^2 + eU}{m_e c^2 + eU/2} \int_{-\infty}^{+\infty} \phi_{ax}(z) dz = const.$$

Als relative Phasenverschiebung von gestreuten und ungestreuten Elektronen ergibt sich

$$(7) \quad \Delta X(r) = X(r) - X_{ax} .$$

$\Delta$X ist in Fig. 7 und 8 in Abhängigkeit vom geometrischen Abstand vom Ursprung der hinteren Brennebene des Objektivs gezeigt.

Die Ortsfrequenz *k* (entspricht der reziproken Koordinate im Fourier-Raum der Objekt-Strukturfaktoren) hängt mit dem geometrischen Abstand *r* in folgender Weise zusammen:

$$(8) \quad k = \frac{r}{\lambda f} \ (f : \text{Brennweite der Objektivlinse}).$$

Die durch die Potenzialverteilung hervorgerufene relative Phasenverschiebung $\Delta X(r)$ kann als elektronenoptische "Zernike"-Phasenplatte (analog"$\lambda$/4-Plättchen" in der Lichtmikroskopie) genutzt werden.

In Fig. 9 und 10 ist die resultierende Phasenkontrast-Transfer-Funktion (PCTF)

$$(9) \quad -1/2 \ PCTF((\Delta X(k)) = \sin \Delta X(k)$$

in Abwesenheit aller anderen Linsenaberrationen (d.h. Aufnahme mit Objekt im Gauss-Fokus, alle höheren Aberrationen vernachlässigt) bei Durchgang des ungestreuten Zentralstrahls durch das Phasenplatten-Loch bei r = 0 und für drei verschiedene Lochradien gezeigt. Es ist dabei angenommen, dass das an der Phasenplatte angelegte Potenzial immer so eingestellt wird, dass

$$\Delta X(r \to \pm\infty) = \pi/2 \text{ oder } 90°.$$

Für ein typisches TEM (U = 200kV, $f$ = 3,0 mm) ist die durch die Phasenplatte (R = 300 nm) erzeugte *PCTF* charakterisiert durch:

<div align="center">Tabelle</div>

| -1/2 *PCTF* | k [nm$^{-1}$] | 1/k [nm] |
|---|---|---|
| 90% | 0,058 (0,012) | 17 (85) |
| 80% | 0,045 (0,009) | 22 (110) |
| 53% | 0,033 (0,007) | 30 (150) |

Die Werte in Klammern gelten für ein 200 kV-TEM mit einer verlängerten Brennweite von f = 15 mm.
Die Brennweite $Z_F$ der Anordnung lässt sich grob abschätzen:

$$(10) \qquad z_F = -2\frac{\phi_a}{E}.$$

Es darf angenommen werden, dass die unerwünschte Ablenkwirkung der Phasenplatte daher sehr schwach ist, nämlich im Bereich von mehreren Metern, während die Brennweite der Objektivlinse des TEM im Bereich von wenigen Millimetern liegt.
Fig. 11 zeigt TEM-Bilder nativer Membranvesikel mit Eiseinbettung.

a) Konventionelle Aufnahme nahe am Gauß'schen Fokus.
b) Aufnahme des gleichen Objektes mit einer Hilbert-Phasenplatte aus Kohlenstiff-Film in der hinteren Brennebene des Objektivs, im Gauß'schen Fokus. Alle Bilder wurden an einem Tecnai G2 "Polara" mit einer Beschleunigungsspannung von 300 kV und einer 4k x 4k-Pixel CCD-Kamera aufgenommen (mit Binning auf 2k x 2k) und zero-loss einergiegefiltert.

**Bezugszeichenliste**

| | |
|---|---|
| 1 | Beleuchtungssystem |
| 2 | Elektronenstrahlen |
| 3 | Objekt |
| 4 | gestreute Elektronenstrahlen |
| 5 | Objektivlinse |
| 6 | Durchleitung der Elektronenstrahlen durch die Phasenplatte |
| 7 | optische Achse |
| 8,8a | Phasenplatte |
| 8c - f | dünne Folie |
| 8g,8h | Phasenplatte |
| 9 | Durchgangsöffnung |
| 9a - c | Löcher |
| 10 | Elektronenstrahlen |
| 11 | Wiedergabeebene |
| 12 | Spannung |
| 12a - c | Spannungsquelle |
| 13 | Potenzial |
| 14a - c | Trägerfilm |
| 15 | Dicke |
| 16,16a - c | Durchmesser |
| 17,18 | links- und rechtsseitige Außenwand |

| 19 | Objektivlinse |
| 30 | Phasenverschiebungsverlauf |
| 21,22 | weitere Linsen |
| 23,24,25 | Elektronenstrahlen |
| 26 | Zwischenbildebene |

**Patentansprüche**

1. Elektronenmikroskop mit einer Elektronenquelle und mindestens einer Objektivlinse (5), wobei das Elektronenmikroskop mit mindestens einer Phasenplatte (8, 8a - h) ausgestattet ist, wobei die Phasenplatte (8, 8a - h) aus mindestens einer dünnen Folie (8, 8a - h), welche zumindest teilweise für Elektronenstrahlen durchlässig ist, aus elektrisch leitfähigem Material besteht, an eine Spannungsquelle (12, 12a - e) zum Anlegen einer vorbestimmbaren elektrischen Spannung angeschlossen ist und mindestens eine Durchgangsöffnung (9, 9a - c) aufweist,
**dadurch gekennzeichnet, dass**
die Durchgangsöffnung (9, 9a - c) in der Nähe einer bezüglich eines zu beobachtenden Objektes hinteren Brennebene der Objektivlinse (5) positioniert ist, in welcher ein von der Objektivlinse gesammeltes Bündel ungestreuter Elektronenstrahlen die geringste Ausdehnung senkrecht zu einer optischen Achse aufweist, so dass ein Zentralstrahl ungestreuter Elektronen durch die Durchgangsöffnung geführt wird, wobei die an der Phasenplatte (8, 8a - h) mittels der Spannungsquelle (12, 12a - e) angelegte Spannung ungleich einer am Ausgang der Elektronenquelle des Elektronenmikroskops vorliegenden Spannung (13) ist.

2. Elektronenmikroskop nach Anspruch 1,
**dadurch gekennzeichnet, dass**
die Phasenplatte (8, 8a - f) senkrecht zu einer optischen Achse (7) des Elektronenmikroskops ausgerichtet ist und die Durchgangsöffnung (9, 9a - c) sich in Verlaufsrichtung der Elektronenstrahlbahn erstreckt.

3. Elektronenmikroskop nach Anspruch 1 oder 2,
**dadurch gekennzeichnet, dass**
die Durchgangsöffnung (9, 9a - c) im Zentrum einer Fläche der Phasenplatte (8, 8a, 8c-f), vorzugsweise auf der optischen Achse (7) des Elektronenmikroskops, angeordnet ist.

4. Elektronenmikroskop nach einem der vorangegangenen Ansprüche ,
**dadurch gekennzeichnet, dass**
die Durchgangsöffnung (9, 9a - c) der Phasenplatte (8, 8a, 8c-f im Querschnitt kreisförmig ausgebildet ist und einen Radius (16, 16a - c) aus einem Bereich von 0,1 -20 $\mu$m aufweist, oder rechteckförmig ausgebildet ist.

5. Elektronenmikroskop nach einem der vorangegangenen Ansprüche,
**dadurch gekennzeichnet, dass**
die an der Phasenplatte (8, 8a - h) mittels der Spannungsquelle (12, 12a -e) angelegte Spannung derart eingestellt ist, dass eine relative Phasenverschiebung (30 - 35) von ungestreuten Elektronenwellen der durch die Durchgangsöffnung (9, 9a - c) hindurchtretenden Elektronenstrahlen zu gestreuten Elektronenwellen der durch die das leitfähige Material hindurchtretenden Elektronenstrahlen bis $\pm$ 90° beträgt.

6. Elektronenmikroskop nach einem vorangegangenen Ansprüche,
**dadurch gekennzeichnet, dass**
die dünne Folie (8, 8a - h) der Phasenplatte (8, 8a - h) zumindest teilweise auf einem Trägerfilm (14a - c), vorzugsweise aus amorphen Material bestehend, angeordnet ist.

7. Elektronenmikroskop nach Anspruch 6,
**dadurch gekennzeichnet, dass**
die dünne Folie (8, 8a - h) der Phasenplatte (8, 8a - h) eine Foliendicke (15, 15a - c) aus einem Bereich von 0,1 - 50 nm und der Trägerfilm (14, 14a- c) eine Filmdicke aus einem Bereich on 1 - 100 nm, aufweist.

8. Elektronenmikroskop nach Anspruch 6,
**dadurch gekennzeichnet, dass**
die dünne Folie (8, 8a - h) der Phasenplatte (8, 8a - h) eine Foliendicke (15, 15a - c) aus einem Bereich von 0,3 - 1,0 nm und der Trägerfilm (14, 14a - c) eine Filmdicke aus einem Bereich von 5 - 20 nm, aufweist.

**9.** Elektronenmikroskop nach einem der vorangegangenen Ansprüche,
**dadurch gekennzeichnet, dass**
die dünne Folie (8, 8a - h) der Phasenplatte (8, 8a - h) aus einem, vorzugsweise amorphen, elektrisch leitfähigem Material, wie Gold, Aluminium, Silber, Platin, Titan und Legierungen hiervon besteht.

**10.** Elektronenmikroskop nach einem der vorangegangenen Ansprüche,
**dadurch gekennzeichnet, dass**
die Phasenplatte (8d - h) in einem Verbund von entlang der Elektronenstrahlbahn übereinander angeordneten Phasenplatten (8d - h) angeordnet ist.

**11.** Elektronenmikroskop nach Anspruch 1,
**dadurch gekennzeichnet, dass**
zumindest Teile, vorzugsweise eine Halbebene einer Beugungsbildebene, des Elektronenmikroskops mit der Phasenplatte (8g, h), auch in einem Phasenplatteverbund (8g,h), abdeckbar sind.

**Claims**

**1.** Electron microscope with an electron source and at least one objective lens (5), the electron microscope being equipped with at least one phase plate (8, 8a-h), the phase plate (8, 8a-h) consisting of at least one thin film (8, 8a-h), which is permeable to electron beams at least in part and is made from electrically conductive material, being connected to a voltage source (12, 12a-e) for applying a predeterminable electric voltage and has at least one through-hole (9, 9a-c), **characterised in that** the through-hole (9, 9a-c) is positioned close to a focal plane, which is to the rear in relation to an object to be observed, of the objective lens (5), in which back focal plane a bundle of unscattered electron beams collected by the objective lens experiences minimal spread perpendicular to an optical axis such that a central beam of unscattered electrons is guided through the through-hole, the voltage applied to the phase plate (8, 8a-h) by means of the voltage source (12, 12a-e) being different from a voltage (13) at the outlet of the electron source of the electron microscope.

**2.** Electron microscope according to claim 1, **characterised in that** the phase plate (8, 8a-f) is oriented perpendicularly to an optical axis (7) of the electron microscope and the through-hole (9, 9a-c) extends in the direction of the course of the electron beam path.

**3.** Electron microscope according to either claim 1 or claim 2, **characterised in that** the through-hole (9, 9a-c) is arranged in the centre of a surface of the phase plate (8, 8a, 8c-f), preferably on the optical axis (7) of the electron microscope.

**4.** Electron microscope according to any of the preceding claims, **characterised in that** the through-hole (9, 9a-c) of the phase plate (8, 8a, 8c-f) is either circular in cross-section having a radius (16, 16a-c) in a range of from 0.1 to 20 $\mu$m, or is rectangular.

**5.** Electron microscope according to any of the preceding claims, **characterised in that** the voltage applied to the phase plate (8, 8a-h) by means of the voltage source (12, 12a-e) is adjusted such that a relative phase shift (30-35) of up to $\pm$ 90° occurs from unscattered electron waves of the electron beams passing through the through-hole (9, 9 a-c) to scattered electron waves of the electron beams passing through the conductive material.

**6.** Electron microscope according to any of the preceding claims, **characterised in that** the thin film (8, 8a-h) of the phase plate (8, 8a-h) is arranged at least in part on a carrier film (14a-c), which preferably consists of amorphous material.

**7.** Electron microscope according to claim 6, **characterised in that** the thin film (8, 8a-h) of the phase plate (8, 8a-h) has a film thickness (15, 15a-c) in a range of from 0.1 to 50 nm and the carrier film (14, 14a-c) has a film thickness in a range of from 1 to 100 nm.

**8.** Electron microscope according to claim 6, **characterised in that** the thin film (8, 8a-h) of the phase plate (8, 8a-h) has a film thickness (15, 15a-c) in a range of from 0.3 to 1.0 nm and the carrier film (14, 14a-c) has a film thickness in a range of from 5 to 20 nm.

9. Electron microscope according to any of the preceding claims, **characterised in that** the thin film (8, 8a-h) of the phase plate (8, 8a-h) consists of an electrically conductive, preferably amorphous, material, such as gold, aluminium, silver, platinum, titanium and alloys thereof.

10. Electron microscope according to any of the preceding claims, **characterised in that** the phase plate (8d-h) is arranged in a group of phase plates (8d-h) arranged one above the other along the electron beam path.

11. Electron microscope according to claim 1, **characterised in that** at least portions, preferably a half-plane of a diffraction-image plane, of the electron microscope can be covered by the phase plate (8g, h), even when it is arranged in a group of phase plates (8g, h).

**Revendications**

1. Microscope à électrons comportant une source d'électrons et au moins une lentille d'objectif (5), ledit microscope à électrons étant équipé d'au moins une lame de phase (8, 8a-h), ladite lame de phase (8, 8a-h) étant réalisée dans au moins une mince feuille (8, 8a-h) de matériau électroconducteur, laquelle laisse passer au moins partiellement les faisceaux d'électrons, étant raccordée à une source de tension (12, 12a-e) pour appliquer une tension électrique prédéfinissable, et comportant au moins un orifice de passage (9, 9a-c),

   **caractérisé en ce que**

   ledit orifice de passage (9, 9a-c) est positionné à proximité d'un plan focal arrière, par rapport à un objet à observer, de la lentille d'objectif (5), dans lequel un groupe de faisceaux d'électrons non dispersés, rassemblé par la lentille d'objectif, possède la plus faible extension perpendiculairement à un axe optique, de telle sorte qu'un faisceau central d'électrons non dispersés est guidé à travers l'orifice de passage, la tension appliquée sur la lame de phase (8, 8a-h) au moyen de la source de tension (12, 12a-e) étant différente d'une tension (13) présente à la sortie de la source d'électrons du microscope à électrons.

2. Microscope à électrons selon la revendication 1, **caractérisé en ce que** la lame de phase (8, 8a-f) est orientée perpendiculairement à un axe optique (7) du microscope à électrons, et l'orifice de passage (9, 9a-c) s'étend dans la direction du tracé de la trajectoire du faisceau d'électrons.

3. Microscope à électrons selon la revendication 1 ou 2, **caractérisé en ce que** l'orifice de passage (9, 9a-c) est disposé au centre d'une surface de la lame de phase (8, 8a, 8c-f), de préférence sur l'axe optique (7) du microscope à électrons.

4. Microscope à électrons selon l'une quelconque des revendications précédentes, **caractérisé en ce que** l'orifice de passage (9, 9a-c) de la lame de phase (8, 8a-h) est réalisé avec une section transversale circulaire avec un rayon (16, 16a-c) situé dans une plage allant de 0,1 à 20 $\mu$m, ou est réalisé avec une section transversale rectangulaire.

5. Microscope à électrons selon l'une quelconque des revendications précédentes, **caractérisé en ce que** la tension appliquée à la lame de phase (8, 8a-h) au moyen de la source de tension (12, 12a-e) est réglée de telle sorte qu'un décalage de phases (30 - 35) relatif des ondes électroniques non dispersées des faisceaux d'électrons passant à travers l'orifice de passage (9, 9a-c) par rapport aux ondes électroniques dispersées des faisceaux d'électrons passant à travers le matériau électroconducteur peut aller jusqu'à $\pm$ 90°.

6. Microscope à électrons selon l'une quelconque des revendications précédentes, **caractérisé en ce que** la mince feuille (8, 8a-h) de la lame de phase (8, 8a-h) est disposée au moins en partie sur un film support (14a - c) réalisé de préférence dans un matériau amorphe.

7. Microscope à électrons selon la revendication 6, **caractérisé en ce que** la mince feuille (8, 8a-h) de la lame de phase (8, 8a-h) a une épaisseur (15, 15a-c) située dans une plage allant de 0,1 à 50 nm et le film support (14a - c) a une épaisseur située dans une plage allant de 1 à 100 nm.

8. Microscope à électrons selon la revendication 6, **caractérisé en ce que** la mince feuille (8, 8a-h) de la lame de phase (8, 8a-h) a une épaisseur (15, 15a-c) située dans une plage allant de 0,3 à 1,0 nm et le film support (14a - c) a une épaisseur située dans une plage allant de 5 à 20 nm.

9. Microscope à électrons selon l'une quelconque des revendications précédentes, **caractérisé en ce que** la mince feuille (8, 8a-h) de la lame de phase (8, 8a-h) est réalisée dans un matériau électroconducteur, de préférence amorphe, tel que l'or, l'aluminium, l'argent, le platine, le titane et des alliages de ceux-ci.

10. Microscope à électrons selon l'une quelconque des revendications précédentes, **caractérisé en ce que** la lame de phase (8d-h) est disposée dans un ensemble de lames de phase (8d-h) disposées les unes au-dessus des autres le long de la trajectoire du faisceau d'électrons.

11. Microscope à électrons selon la revendication 1, **caractérisé en ce qu'**au moins des parties, de préférence un demi-plan d'un plan focal de diffraction, du microscope à électrons peuvent être recouverts par la lame de phase (8g-h), également dans un ensemble de lames de phase (8g, h).

Beleuchtungs-System — 1

2

Objektebene

3

4

5

7

6

8

hintere Brennebene

U

9

12

10

11

1. Zwischenbild

Fig. 1

Fig. 2

Fig. 3

Fig. 4

Fig. 5

1

Beleuchtungs-System

2

Objektebene

3

4

5

6

hintere Brennebene

1. Phasenplatte U₁

12d

8g

7

11

1. Zwischenbild

19

20

21

23 22

24

8h

konjugierte
Brennebene

U₂

12e

25

Zwischenbild

26

Fig. 6

Fig. 7

Fig. 8

Fig. 9

Fig. 10

a)

500 nm

Fig. 11a

Fig. 11b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1329936 A

- DE 10114949 A1

**In der Beschreibung aufgeführte Nicht-Patentliteratur**

- **S. ZEMLIN.** *Cryst. Res. Technol.,* 1998, vol. 33, 1097-1111